# EUROPEAN PATENT APPLICATION

(11) **EP 3 869 087 A1**
(43) Date of publication of application: **25.08.2021**
(21) Application number: 18936993.7
(22) Date of filing: 18.10.2018
(51) Int. Cl.: F21S 41/141, F21S 41/20, F21S 41/30, H05B 33/08, F21Y 115/10

(54) **VEHICULAR LAMP USING SEMICONDUCTOR LIGHT-EMITTING DIODES**

(71) Applicant: ZKW Group GmbH, 3250 Wieselburg (AT)
(72) Inventor: KIM, Yongkyo, Seoul 06772 (KR); SEOL, Juhwan, Seoul 06772 (KR); LEE, Yeonji, Seoul 06772 (KR)
(74) Representative: Patentanwaltskanzlei Matschnig & Forsthuber OG
(86) International application number: PCT/KR2018/012318
(87) International publication number: WO 2020/080570

(57) **Abstract**

The present disclosure provides a vehicle lamp using a semiconductor light-emitting device, including a substrate; a plurality of first semiconductor light-emitting devices disposed on the substrate, disposed in a row, and emitting light in a predetermined color, a plurality of second semiconductor light-emitting devices disposed on the substrate, disposed in a row in parallel with the first semiconductor light-emitting devices, and emitting light in a different color from the first semiconductor light-emitting devices, a phosphor layer disposed to be overlapped with the first semiconductor light-emitting devices and the second semiconductor light-emitting devices, and converting wavelengths of light, and an optical unit having a light incident surface, reflecting or refracting light incident on the light incident surface, and having at least a part of the light incident surface overlapped with the a phosphor layer, wherein the phosphor layer selectively converts only light emitted from one of the first semiconductor light-emitting device and the second semiconductor light-emitting device.

## Description

### TECHNICAL FIELD

The present disclosure relates to a vehicle lamp (or car lamp), and more particularly, a vehicle lamp using a semiconductor light-emitting device.

### BACKGROUND ART

A vehicle is equipped with various lamps having lighting functions and signaling functions. In general, halogen lamps or gas discharge lamps are usually used, but in recent years, light-emitting diodes (LEDs) are in the spotlight as light sources for vehicle lamps.

The LED can enhance a degree of freedom for design of a lamp by minimizing a size thereof and exhibit economical efficiency by virtue of a semi-permanent lifespan, but most of the LEDs are currently produced in a form of a package. The LED itself other than the package is under development as a semiconductor light-emitting device of converting a current into light, namely, an image displaying light source equipped in an electronic device such as an information communication device.

Vehicle lamps ever developed use the LEDs in the package form and thereby have disadvantages, such as a low mass production yield rate, high fabrication costs and low flexibility.

Meanwhile, as a demand for intelligent lamps increases, there is an increasing demand for lamps that can emit light in a plurality of colors. However, there is a problem that a structure of the lamp becomes more complicated as the number of colors implemented in the lamp increases.

### DISCLOSURE

### TECHNICAL PROBLEM

The present disclosure is directed to providing a vehicle lamp capable of emitting light in a plurality of colors.

In addition, in emitting a plurality of colors of light in a single lamp, the present disclosure is directed to providing a structure capable of minimizing the number of optical instruments required for a lamp.

### TECHNICAL SOLUTION

In order to achieve the above-described aspect, the present disclosure provides a vehicle lamp using a semiconductor light-emitting device, including a substrate, a plurality of first semiconductor light-emitting devices disposed on the substrate, disposed in a row, and emitting light in a predetermined color, a plurality of second semiconductor light-emitting devices disposed on the substrate, disposed in a row in parallel with the first semiconductor light-emitting devices, and emitting light in a different color from the first semiconductor light-emitting devices, a phosphor layer disposed to be overlapped with the first semiconductor light-emitting devices and the second semiconductor light-emitting devices, and converting wavelengths of light, and an optical unit having a light incident surface, reflecting or refracting light incident on the light incident surface, and having at least a part of the light incident surface overlapped with the a phosphor layer, wherein the phosphor layer selectively converts only light emitted from one of the first semiconductor light-emitting device and the second semiconductor light-emitting device.

In one embodiment, each of the first semiconductor light-emitting devices and the second semiconductor light-emitting devices is disposed so as to face the light incident surface of the optical unit.

In one embodiment, a part of the lights emitted from each of the first semiconductor light-emitting devices and the second semiconductor light-emitting devices transmits the phosphor layer.

In one embodiment, the first semiconductor light-emitting devices may emit blue light and the phosphor layer may absorb blue light and emit yellow light.

In one embodiment, the second semiconductor light-emitting devices may emit red light.

An embodiment of the present disclosure provides a vehicle lamp using a semiconductor light-emitting device that may further include a controller for controlling a lighting-on of the first semiconductor light-emitting devices and the second semiconductor light-emitting devices.

In one embodiment, the controller selectively may light on only one of the first semiconductor light-emitting devices and the second semiconductor light-emitting devices.

In one embodiment, the controller may simultaneously light on the first semiconductor light-emitting devices and the second semiconductor light-emitting devices, and control such that an amount of light emitted from the first semiconductor light-emitting devices is more than that of light emitted from the second semiconductor light-emitting devices.

In one embodiment, the optical unit may be a reflection plate for reflecting light.

In one embodiment, the optical unit may be a lens for concentrating light.

### ADVANTAGEOUS EFFECT

According to the present disclosure, a distance between different types of light sources may be minimized, it is possible to minimize the number of optical instruments required for the lamp even when a plurality of different light sources are used.

### BRIEF DESCRIPTION OF THE DRAWINGS

FIG. 1 is a conceptual diagram illustrating one embodiment of a vehicle lamp using a semiconductor light-emitting device of the present disclosure.
FIG. 2 is a partially enlarged view of a part A of FIG. 1, FIG.3 is a cross-sectional view, and FIG. 4 is a conceptual diagram illustrating a flip chip semiconductor light-emitting device of FIG. 3.
FIG. 5 is a plan view of a lamp according to the present disclosure.
FIGS. 6A and 6B are conceptual diagrams illustrating trajectories of lights reflected from a reflection plate according to embodiments of the present disclosure.
FIGS. 7A and 7B are conceptual diagrams illustrating trajectories of lights concentrated by a lens.
FIG. 8 is a conceptual diagram illustrating a cross-section of a partition wall.
FIGS. 9 to 11 are conceptual diagrams illustrating modified embodiments according to the present disclosure.
FIG.12 illustrates a spectrum of white light formed from a lamp according to one embodiment of the present disclosure.

### MODES FOR CARRYING OUT THE PREFERRED EMBODIMENTS

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings.

It will be understood that when an element such as a layer, area or substrate is referred to as being "on" another element, it can be directly on the element, or one or more intervening elements may also be present.

A vehicle lamp described in this specification may include a head lamp, a tail lamp, a position lamp, a fog lamp, a turn signal lamp, a brake lamp, an emergency lamp, a backup lamp, and the like. However, it will be readily apparent to those skilled in the art that the configuration according to the embodiments described herein may also be applied to a new product type that will be developed later if the device is a device capable of emitting light.

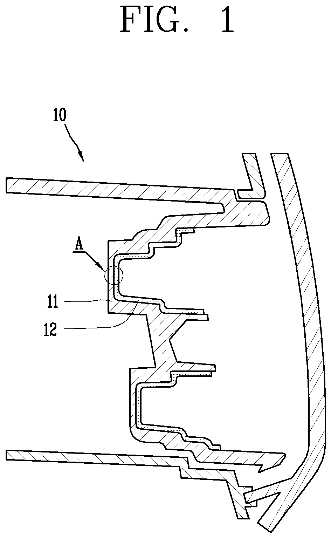

FIG. 1 is a conceptual view illustrating one embodiment of a lamp for a vehicle (or a vehicle lamp) using a semiconductor light-emitting device according to the present disclosure.

A vehicle lamp 10 according to one embodiment of the present disclosure includes a frame 11 fixed to a vehicle body, and a light source unit 12 installed on the frame 11.

A wiring line for supplying power to the light source unit 12 may be connected to the frame 11, and the frame 11 may be fixed to the vehicle body directly or by using a bracket. According to the present disclosure, the vehicle lamp 10 may be provided with a lens unit to more diffuse and sharpen light emitted from the light source unit 12.

The light source unit 12 may be a flexible light source unit that can be curved, bent, twisted, folded, or rolled by external force.

In a non-curved state of the light source unit 12 (for example, a state having an infinite radius of curvature, hereinafter, referred to as a first state), the light source unit 12 is flat. When the first state is switched to a state that the light source unit 12 is bent by an external force (e.g., a state having a finite radius of curvature, hereinafter, referred to as a second state), the flexible light source unit may have a curved surface with at least part curved or bent.

A pixel of the light source unit 12 may be implemented by a semiconductor light-emitting device. The present disclosure exemplarily illustrates a light-emitting diode (LED) as a type of semiconductor light-emitting device for converting current into light. The LED may be a light-emitting device having a small size, and may thus serve as a pixel even in the second state.

Meanwhile, the light source unit 12 according to the present disclosure includes a unit light source, a base substrate, and a connection electrode. Hereinafter, the above-mentioned constituent elements (components) will be described in detail.

The light source unit 12 may be provided with only the unit light source. Hereinafter, the unit light source will be described in detail based on the light source unit 12 provided with only the unit light source.

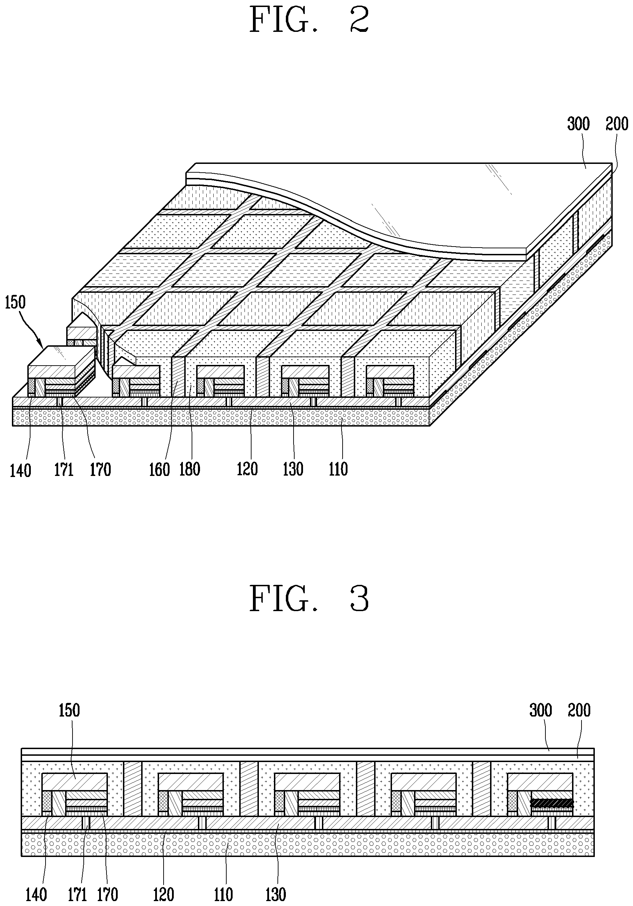

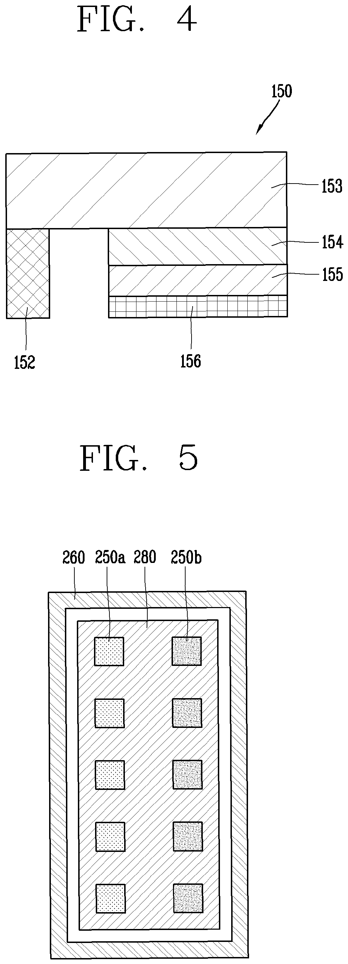

FIG. 2 is a partially enlarged view of a part A in FIG. 1, FIG. 3 is a sectional view, and FIG. 4 is a conceptual view illustrating a flip chip semiconductor light-emitting device of FIG. 3.

Referring to FIGS. 2, 3 and 4, a passive matrix (PM) type semiconductor light-emitting device is used as the unit light source 100 using the semiconductor light-emitting device. However, an example described below may also be applicable to an active matrix (AM) type semiconductor light-emitting device.

The unit light source 100 includes a substrate 110, a first electrode 120, a second electrode 140, and a plurality of semiconductor light-emitting devices 150.

The substrate 110 may be a base layer on which a structure is formed through an entire process, and may be a wiring substrate on which the first electrode 120 is disposed. The substrate 110 may be formed of glass or polyimide (PI) to implement a flexible light source unit. In addition, the substrate 110 may be made of a thin metal. The substrate 110 may alternatively be made of any material with insulating property and flexibility, for example, polyethylene naphthalate (PEN), polyethylene terephthalate (PET), and the like. Furthermore, the substrate 110 may be either one of transparent and non-transparent materials.

Meanwhile, a heat dissipating sheet, a heat sink, or the like may be mounted on the substrate 110 to realize a heat dissipating function. In this case, the heat dissipating sheet, the heat sink, or the like may be mounted on an opposite surface to a surface on which the first electrode 120 is disposed.

The first electrode 120 is disposed on the substrate 110, and may be formed as a surface-shaped electrode. Therefore, the first electrode 120 may be an electrode layer disposed on the substrate, and may serve as a data electrode.

As illustrated, an insulating layer 130 may be disposed on the substrate 110 on which the first electrode 120 is located, and an auxiliary electrode 170 may be disposed on the insulating layer 130. In this case, a configuration in which the insulating layer 130 is deposited on the substrate 110 may be a single wiring substrate. More specifically, the insulating layer 130 may be formed of a flexible insulating material, such as polyimide (PI), PET, or PEN, and may be formed integrally with the substrate 110 to form a single substrate.

The auxiliary electrode 170 is an electrode that electrically connects the first electrode 120 and the semiconductor light-emitting device 150, and is disposed on the insulating layer 130 to correspond to a position of the first electrode 120. For example, the auxiliary electrode 170 may have a dot-like shape and may be electrically connected to the first electrode 120 by an electrode hole 171 formed through the insulating layer 130. The electrode hole 171 may be formed by filling a conductive material in a via hole.

Since the semiconductor light-emitting device 150 has excellent brightness, it can constitute an individual unit pixel even though it has a small size. The size of the individual semiconductor light-emitting device 150 may be less than 80 µm in the length of one side thereof, and may be a rectangular or square shaped device. In this case, an area of the single semiconductor light-emitting device is in the range of 10-10 to 10-5 m2, and an interval between the light-emitting devices may be in the range of 100 um to 10 mm.

Referring to FIG. 4, the semiconductor light-emitting device may be a flip chip type light-emitting device.

For example, the semiconductor light-emitting device includes a p-type electrode 156, a p-type semiconductor layer 155 on which the p-type electrode 156 is formed, an active layer 154 disposed on the p-type semiconductor layer 155, an n-type semiconductor layer 153 disposed on the active layer 154, and an n-type electrode 152 disposed on the n-type semiconductor layer 153 with being spaced apart from the p-type electrode 156 in a horizontal direction. In this case, the p-type electrode 156 may be electrically connected to the auxiliary electrode 170, and the n-type electrode 152 may be electrically connected to the second electrode 140.

Referring back to FIGS. 2 and 3, the auxiliary electrode 170 may be formed long in one direction, and one auxiliary electrode may be electrically connected to the plurality of semiconductor light-emitting devices 150. For example, the p-type electrodes of the left and right semiconductor light-emitting devices based on the auxiliary electrode may be electrically connected to one auxiliary electrode.

In addition, the plurality of semiconductor light-emitting devices 150 constitute a light-emitting device array, and a phosphor layer 180 is formed on the light-emitting device array.

The light-emitting device array may include a plurality of semiconductor light-emitting devices having different brightness values. Each of the semiconductor light-emitting devices 150 constitutes a unit pixel and is electrically connected to the first electrode 120. For example, the first electrode 120 may be in plurality. The semiconductor light-emitting devices, for example, may be arranged in several rows, and the semiconductor light-emitting devices in each row may be electrically connected to one of the plurality of first electrodes.

In addition, since the semiconductor light-emitting devices are connected in a form of a flip chip, the semiconductor light-emitting devices grown on a transparent dielectric substrate can be used. The semiconductor light-emitting devices may be, for example, nitride semiconductor light-emitting devices. Since the semiconductor light-emitting device 150 has excellent brightness, it can constitute an individual unit pixel even though it has a small size.

Meanwhile, the second electrode 140 is located between the semiconductor light-emitting devices 150 and is electrically connected to the semiconductor light-emitting devices 150. For example, the semiconductor light-emitting devices 150 may be disposed in a plurality of rows, and the second electrode 140 may be disposed between the rows of the semiconductor light-emitting devices 150.

In this case, the second electrode 140 may be located between the semiconductor light-emitting devices 150 because a distance between the semiconductor light-emitting devices 150 forming the individual pixels is sufficiently large. In addition, the second electrode 140 may be formed as a bar-like electrode which is long in one direction.

At this time, the color filter 200 may also be laminated on the phosphor layer 180 to improve color purity of converted light. In addition, the color filter 200 may be covered with a protective layer 300 to protect the light source unit from moisture, oxygen, and external impact. At this time, the protective layer 300 may be formed by bonding a film or coating resin.

Meanwhile, partition walls 160 may be formed between the semiconductor light-emitting devices 150 to prevent light emitted from each of the semiconductor light-emitting devices from interfering with each other. In this case, each partition wall 160 may serve to separate the individual unit pixels from each other.

The partition walls 160 are formed higher than the semiconductor light-emitting devices with respect to a thickness direction of the semiconductor light-emitting device. In this way, the partition walls 160 absorb or reflect light output from the phosphor layers disposed on the semiconductor light-emitting devices as well as light emitted from the semiconductor light-emitting devices. Specifically, the partition walls 160 absorb or reflect light directed toward a side surface of the semiconductor light-emitting devices among the light emitted from the semiconductor light-emitting devices and the phosphor layers.

For this purpose, the partition wall 160 may be formed of a black material having a high light absorption rate or a white material having high reflectance. The partition wall 160 may be made of a glossy metal or alloy, such as Ni, Cr, Cu, or the like, which has high reflectance.

The partition walls 160 and the phosphor layers 180 may be implemented in various forms. Hereinafter, various embodiments constituting the partition wall 160 and the phosphor layer 180 will be described.

Hereinafter, for convenience of description, description of the other components of the components, which constitute the light source unit, except for the semiconductor substrate 110, the semiconductor light-emitting device 150, the partition wall 160 and the phosphor layer 180, will be omitted, but those skilled in the art may easily understand those components which are not described with reference to FIGS. 2 to 4.

The vehicle lamp according to the present disclosure reflects or refracts the light emitted from the light-emitting device at least once to emit to the outside. When light is reflected or refracted, a separate optical structure is disposed, and this is a factor to complicate a structure of a lamp and to increase a size of the lamp.

A reflection or refraction effect of an optical structure may be different depending on a relative position of the optical structure and a light source. Accordingly, a position on which the light source may be placed with respect to the specific optical structure is limited. When a plurality of light sources are disposed to be spaced apart from each other at a predetermined distance or more, at least one of the plurality of light sources is difficult to be applied to an effect of the optical structure.

Therefore, as a type of light source included in a single lamp increases, the optical structure required for the amp may increase. For example, when a single lamp is implemented to emit red and blue light selectively, the single lamp should include both a structure for reflecting or refracting red light and a structure for reflecting or refracting blue light.

The present disclosure provides a structure in which the effect of one optical structure may be applied to a plurality of different types of light sources.

FIG. 5 is a plan view of the lamp according to the present disclosure.

The present disclosure provides a structure that minimizes a distance between semiconductor light-emitting devices emitting different lights. Specifically, the present disclosure includes a substrate, first semiconductor light-emitting devices 250a, second semiconductor light-emitting devices 250b, a phosphor layer 280, and an optical unit. Hereinafter, the above-described components will be described in detail.

The first semiconductor light-emitting device 250a is disposed on the substrate, and disposed in a row, and emitting light in a predetermined color. The first semiconductor light-emitting device 250a may be the above-described flip chip typed semiconductor light-emitting device, but is not limited thereto.

The second semiconductor light-emitting device 250b is emitting light in a different color from the first semiconductor light-emitting device 250a, and disposed in a row in parallel with the first semiconductor light-emitting device 250a.

For example, the first semiconductor light-emitting device 250a may be a semiconductor light-emitting device emitting blue light, and the second semiconductor light-emitting device 250a may be a semiconductor light-emitting device emitting red light.

When the first semiconductor light-emitting device 250a is disposed in one row and the second semiconductor light-emitting device 250b is disposed in parallel with the rows of the first semiconductor light-emitting device 250a, a total of two rows of semiconductor light-emitting devices are disposed. When the first semiconductor light-emitting devices 250a and 250b emit light simultaneously, the lights emitted from the two types of light-emitting devices are mixed, so that it is difficult to implement each unique color of the first semiconductor light-emitting device 250a and the second semiconductor light-emitting device 250b.

In general, to prevent this, a partition wall having high reflectance or high absorption between two types of different semiconductor light-emitting devices is disposed. Since the partition wall should be disposed between the semiconductor light-emitting devices, this becomes a factor of increasing the distance between the semiconductor light-emitting devices.

In order to reduce the distance between different types of semiconductor light-emitting devices, the above-described partition wall is not present in the lamp according to the present disclosure. Since there is no space occupied by the partition wall, in the lamp according to the present disclosure, two different types of semiconductor light-emitting devices may be disposed within a predetermined distance.

The phosphor layer 280 is disposed to be overlapped with the first semiconductor light-emitting devices and the second semiconductor light-emitting devices, and selectively converts only the light emitted from any one of the first semiconductor light-emitting devices and the second semiconductor light-emitting devices. Light whose wavelength is not converted transmits the phosphor layer 280. That is, most of the lights, which are emitted from any one and the other one of the first semiconductor light-emitting devices 250a and the second semiconductor light-emitting devices 250b, transmit the phosphor layer 280.

The phosphor layer 280 absorbs light having a predetermined wavelength and emits light having a wavelength different from that of the predetermined wavelength. A wavelength range band of an absorbable light is different depending on a fluorescent material constituting the phosphor layer 280. The phosphor layer 280 absorbs only light emitted from one of the first semiconductor light-emitting device 250a and the second semiconductor light-emitting device 250b.

However, the phosphor layer 280 may absorb a very little part of the light emitted from the second semiconductor light-emitting devices 250a and 250b. Even in such a case, in the present specification, the phosphor layer is configured to absorb only light emitted from any one of the first and second semiconductor light-emitting devices 250a and 250b.

Since no separate structure is disposed between the first semiconductor light-emitting device 250a and the second semiconductor light-emitting device 250b, the phosphor layer 280 may be disposed between the first semiconductor light-emitting device 250a and the second semiconductor light-emitting device 250b.

In one embodiment of the present disclosure, the first semiconductor light-emitting device 250a may be configured to emit blue light, the second semiconductor light-emitting device 250b may be configured to emit red light, and the phosphor layer 280 may be configured to absorb blue light to emit yellow light. Here, the phosphor layer 280 may be configured to transmit most of the red light, and absorb only a very little part of the red light.

In the above embodiment, when only the first semiconductor light-emitting devices 250a are lighted on, white light is emitted from the lamp, and when only the second semiconductor light-emitting devices 250b are lighted on, red light is emitted from the lamp.

Meanwhile, the optical unit include a light incident surface, and reflects or refracts the light incident on the light incident surface. At least a part of the light incident surface is disposed to be overlapped with the phosphor layer. Accordingly, the light emitted from the phosphor layer may reach the light incident surface.

Meanwhile, each of the first semiconductor light-emitting devices 250a and the second semiconductor light-emitting devices 250b is disposed so as to face the light incident surface of the optical unit.

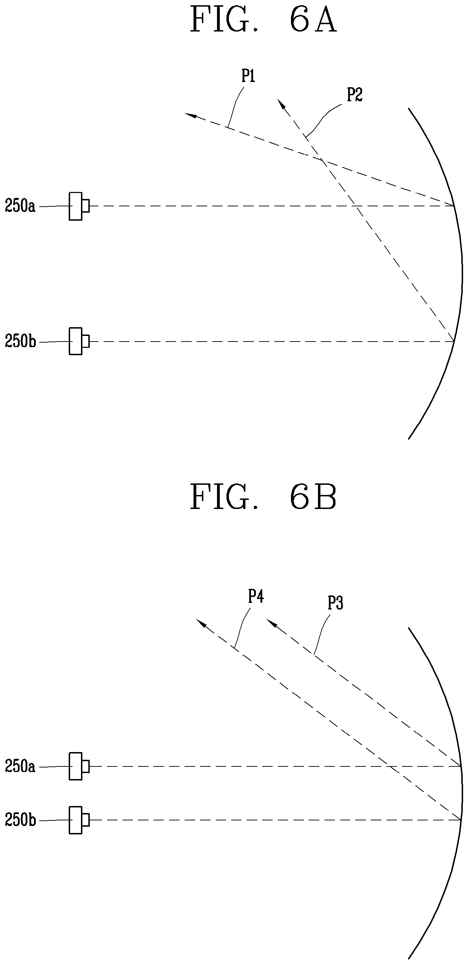

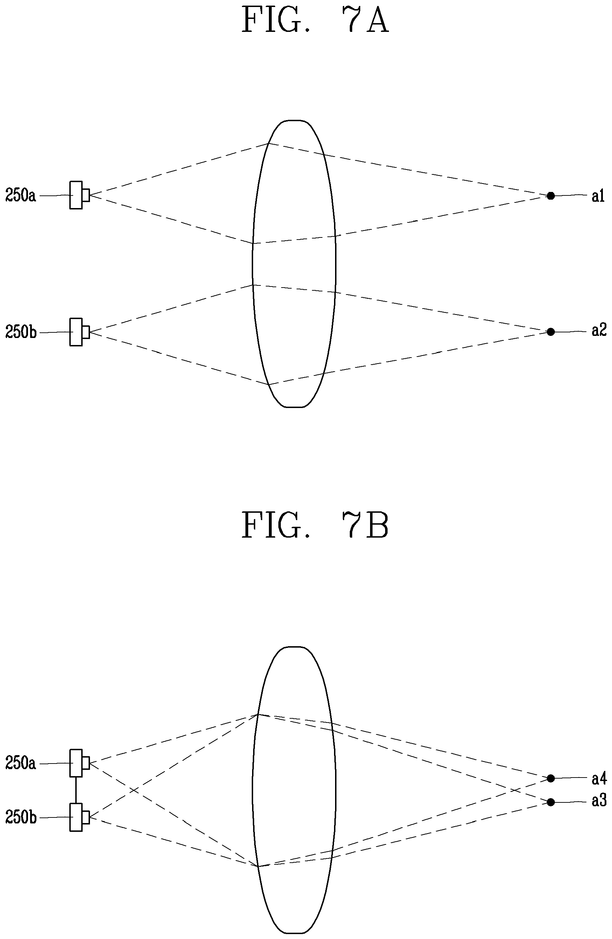

FIGS. 6A and 6B are conceptual diagrams illustrating trajectories of lights reflected from a reflection plate, and FIGS. 7A and 7B are conceptual diagrams illustrating trajectories of lights concentrated by a lens.

In one embodiment, referring to FIGS. 6A and 6B, the optical unit may be a reflective layer. The reflective layer reflects light emitted from the semiconductor light-emitting devices 250a or 250b and directing toward a first direction, and makes the light direct toward a second direction.

The direction in which the light is reflected may vary, according to the angle at which the light is incident to the reflective layer. As shown in FIG. 6A, when the first semiconductor light-emitting device 250a and the second semiconductor light-emitting device 250b are disposed to be spaced apart from each other at a predetermined distance or more, the light emitted from each of the first semiconductor light-emitting device 250a and second semiconductor light-emitting device 250b is incident on the reflective layer at different angles. Therefore, the lights emitted from each of the first semiconductor light-emitting device 250a and the second semiconductor light-emitting device 250b travels in different directions with each other after the lights are reflected by the reflective layer respectively. When the lights emitted from each of the first and second semiconductor light-emitting devices 250a and 250b are to be irradiated in the same direction, two reflective layers are necessary.

As shown in FIG. 6B, according to the present disclosure, since the first semiconductor light-emitting device 250a and the second semiconductor light-emitting device 250b are disposed to be very close to each other, the lights emitted from each of the first semiconductor light-emitting device 250a and the second semiconductor light-emitting device 250b are incident on the reflective layer at an almost same incident angle. For this reason, according to the present disclosure, it is possible to minimize the number of the optical unit necessary for reflecting light.

In another embodiment, referring to FIGS. 7A and 7B, the optical unit may be a lens for concentrating light. The lens concentrates the light emitted from the semiconductor light-emitting device on one region.

Depending on an incident angle of the light on the lens, a region on which the light is concentrated may be different. As shown in FIG. 7A, when the first semiconductor light-emitting device 250a and the second semiconductor light-emitting device 250b are disposed to be spaced apart from each other at a predetermined distance or more, the lights emitted from each of the first semiconductor light-emitting device 250a and second semiconductor light-emitting device 250b are incident on the lens at different angles. Therefore, the lights emitted from each of the first semiconductor light-emitting device 250a and the second semiconductor light-emitting device 250b are concentrated on different region. When the lights emitted from each of the first semiconductor light-emitting device 250a and the second semiconductor light-emitting device 250b are to be concentrated on the same region, two lenses are necessary.

As shown in FIG. 7B, according to the present disclosure, since the first semiconductor light-emitting device 250a and the second semiconductor light-emitting device 250b are disposed to be very close to each other, the lights emitted from each of the first semiconductor light-emitting device 250a and the second semiconductor light-emitting device 250b are incident on the lens at an almost same angle. For this reason, according to the present disclosure, it is possible to minimize the number of the optical unit necessary for reflecting light.

As described above, according to the present disclosure, since the distance between the different types of semiconductor light-emitting devices may be minimized, it is possible to minimize the number of the optical units necessary for the lamp.

Meanwhile, again referring to FIG. 5, the lamp according to the present disclosure may further include a partition wall 260 surrounding the first semiconductor light-emitting device 250a and the second semiconductor light-emitting device 250b.

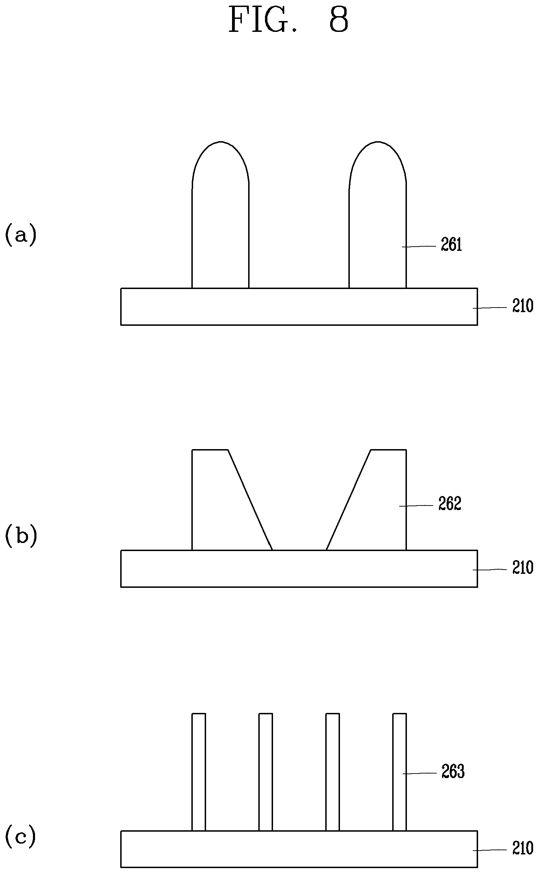

FIG. 8 is a conceptual diagram illustrating a cross-section of a partition wall.

The partition wall 260 increases the light extraction efficiency of the lamp by reflecting the lights emitted from each of the first semiconductor light-emitting device 250a and the second semiconductor light-emitting device 250b and

In addition, the partition wall 260 serves to form the phosphor layer 280 only up to a predetermined height. In detail, the phosphor layer 280 may be formed by hardening a resin having fluidity. The resin is applied on a substrate at which semiconductor light-emitting devices are disposed, so that it is difficult to control a thickness of the phosphor layer due to the fluidity of the resin. When the partition wall 260 is disposed to surround the first semiconductor light-emitting device 250a and the second semiconductor light-emitting devices 250b and then the resin is coated, the resin forms a layer only between the partition walls 260. When using this, it is possible to adjust a height of the phosphor layer 280.

As shown in (a) to (c) of FIGS. 8, the partition wall 260 may be formed in various forms, and a thickness and a side surface shape of the phosphor layer 280 may be different depending on a form of the partition wall 260.

Meanwhile, the semiconductor light-emitting devices and the phosphor layer may be disposed in various forms in the partition wall 260.

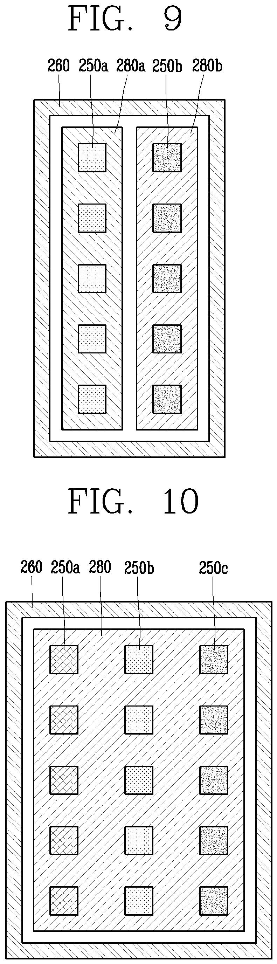

FIGS. 9 to 11 are conceptual diagrams illustrating modified embodiments according to the present disclosure.

Referring to FIG. 9, each of two types of semiconductor light-emitting devices 250a and 250b are disposed in a row between the partition walls 260, and each of the two types of semiconductor light-emitting devices 250a and 250b may be disposed to be covered by different types of phosphor layers 280a and 280b.

In another embodiment, as shown in FIG. 10, each of the three types of semiconductor light-emitting devices 250a to 250c may be disposed in a row between the partition walls 260. When the three types of semiconductor light-emitting devices are disposed to be close enough to one another, three different types of colors may be emitted to the outside by one optical unit.

As described above, the types of semiconductor light-emitting devices disposed between the partition walls 260 are not limited to two types. In addition, different types of phosphor layers may be disposed between the partition walls 260 as necessary.

Meanwhile, the present disclosure may further include a controller for controlling a lighting-on of the first semiconductor light-emitting devices 250a and the second semiconductor light-emitting devices 250b. The controller may selectively control the lighting-on of the first semiconductor light-emitting devices 250a and the second semiconductor light-emitting devices 250b.

Meanwhile, the controller may receive a control command generated while driving the vehicle, and selectively light on the first semiconductor light-emitting devices 250a and the second semiconductor light-emitting devices 250b based on the control command.

Here, the control command may be generated by a sensing result of a sensing unit disposed in a vehicle or by a user input applied via an interface unit.

The sensing unit may sense a state of the vehicle. The sensing unit may include an attitude sensor (for example, a yaw sensor, a roll sensor, and a pitch sensor), a collision sensor, a wheel sensor, a speed sensor, an inclination sensor, a weight sensor, a heading sensor, a yaw sensor, a gyro sensor, a position module, a vehicle forward/reverse sensor, a battery sensor, a fuel sensor, a tire sensor, a steering sensor by rotation of a steering wheel, a temperature sensor inside a vehicle, a humidity sensor inside a vehicle, a ultrasonic sensor, an illuminance sensor, an accelerator pedal position sensor, a brake pedal position sensor, and the like.

The sensing unit may obtain sensing signals with respect to a vehicle attitude information, vehicle collision information, vehicle direction information, vehicle position information (GPS information), vehicle angle information, vehicle speed information, vehicle acceleration information, vehicle tilting information, vehicle forward/reverse information, battery information, fuel information vehicle, tire information, vehicle lamp information, temperature information inside a vehicle, humidity information inside a vehicle, steering wheel rotation angle information, vehicle external illumination, pressure on accelerator pedal, vehicle external illumination, pressure on the accelerator pedal, pressure on the brake pedal, and the like.

In addition, the sensing unit may further include an accelerator pedal sensor, a pressure sensor, an engine speed sensor, an air flow sensor (AFS), an intake temperature sensor (ATS), a water temperature sensor (WTS), a throttle position sensor (TPS), a TDC sensor, a crank angle sensor (CAS), and the like.

The interface unit may serve as a path to various types of external devices connected to the vehicle. For example, the interface unit may include a port that can be connected to the mobile terminal, and may be connected to the mobile terminal via the port. In this case, the interface unit may exchange data with the mobile terminal.

The controller disposed in the vehicle may generate the control command for controlling the lamp based on a sensing result of the sensing unit or a user input applied through the interface unit.

Meanwhile, the controller may light on the first and second semiconductor light-emitting devices 250a and 250b simultaneously, and control a current or a voltage applied to each of the first and second semiconductor light-emitting devices 250a and 250b such that an amount of light emitted from the first semiconductor light-emitting devices 250a is controlled to be more than that of light emitted from the second semiconductor light-emitting device 250b.

In one embodiment, the first semiconductor light-emitting device 250a may configured to emit blue light, and the second semiconductor light-emitting device 250b may configured to emit red light. Meanwhile, the phosphor layer may absorb blue light to emit yellow light. When the first semiconductor light-emitting device 250a is lighted on, white light is formed by mixing the wavelength-converted yellow light and the wavelength-unconverted blue light in the phosphor layer.

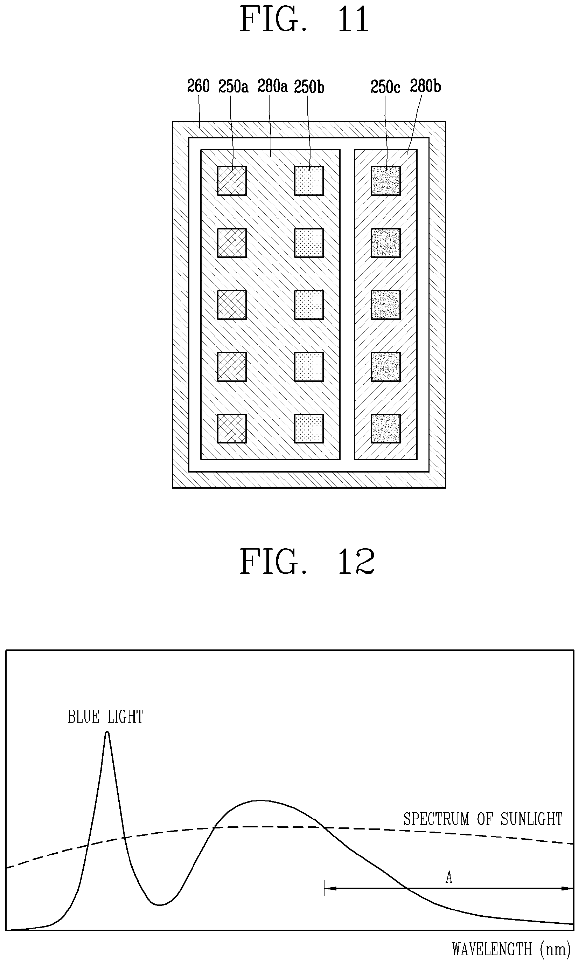

Although the white light is mixed with light in all visible light bands, visibility may be deteriorated since an amount of light in some wavelength bands is smaller than that of sunlight. In particular, referring to FIG. 11, the white light has an amount of light in a wavelength range A corresponding to red which is lower than that of sunlight. In order to increase the visibility of the white light, red light may be mixed with the white light. However, when an amount of red light mixed with the white light is too large, the white light may be seen in red. To prevent this, the red light mixed with the white light should be a very little amount.

The controller according to the present disclosure may light on the first semiconductor light-emitting device which is emitting blue light and the second semiconductor light-emitting device which is emitting red light, simultaneously and making an amount of the light emitted from the first semiconductor light-emitting device larger than that of the of the light emitted from the second semiconductor light-emitting device, and thus visibility of white light can be improved.

It will be apparent to those skilled in the art that the present disclosure may be embodied in other specific forms without departing from the spirit or essential characteristics thereof.

Therefore, it should also be understood that the above-described embodiments are not limited by any of the details of the foregoing description, unless otherwise specified, but rather should be construed broadly within its scope as defined in the appended claims, The scope of the present disclosure should be determined by rational interpretation of the appended claims, and all changes within the scope of equivalents of the present disclosure are included in the scope of the present disclosure.

## Claims

1. A vehicle lamp, comprising:
a substrate;
a plurality of first semiconductor light-emitting devices disposed on the substrate, and disposed in a row, and emitting light in a predetermined color;
a plurality of second semiconductor light-emitting devices disposed on the substrate, disposed in a row in parallel with the first semiconductor light-emitting devices, and emitting light in a different color from the first semiconductor light-emitting devices;
a phosphor layer disposed to be overlapped with the first semiconductor light-emitting devices and the second semiconductor light-emitting devices, and converting wavelengths of light; and
an optical unit having a light incident surface, reflecting or refracting light incident on the light incident surface, and having at least a part of the light incident surface overlapped with the phosphor layer,
wherein the phosphor layer selectively converts only light emitted from one of the first semiconductor light-emitting device and the second semiconductor light-emitting device.

2. The vehicle lamp of claim 1,
wherein each of the first semiconductor light-emitting devices and the second semiconductor light-emitting devices is disposed so as to face a light incident surface of the optical unit.

3. The vehicle lamp of claim 2,
wherein a part of the lights emitted from each of the first semiconductor light-emitting devices and the second semiconductor light-emitting devices transmits the phosphor layer.

4. The vehicle lamp of claim 1,
wherein the first semiconductor light-emitting devices emit blue light, and the phosphor layer absorbs blue light and emits yellow light.

5. The vehicle lamp of claim 4,
wherein the second semiconductor light-emitting devices emit red light.

6. The vehicle lamp of claim 5,
further comprising:
a controller for controlling a lighting-on of the first semiconductor light-emitting devices and the second semiconductor light-emitting devices.

7. The vehicle lamp of claim 6,
wherein the controller selectively lights on only one of the first semiconductor light-emitting devices and the second semiconductor light-emitting devices.

8. The vehicle lamp of claim 6,
wherein the controller simultaneously lights on the first semiconductor light-emitting devices and the second semiconductor light-emitting devices, and controls such that an amount of light emitted from the first semiconductor light-emitting devices is more than that of light emitted from the second semiconductor light-emitting devices.

9. The vehicle lamp of claim 1,
wherein the optical unit is a reflection plate for reflecting light.

10. The vehicle lamp of claim 1,
wherein the optical unit is a lens for concentrating light.
